# FASCICULE DE BREVET EUROPEEN

(11) **EP 1 030 419 B1**
(45) Date de publication et mention de la délivrance du brevet: **02.01.2004**
(21) Numéro de dépôt: 00400415.6
(22) Date de dépôt: 14.02.2000
(51) Int. Cl.: H01S 5/14

(54) **Source laser à cavité externe accordable en longueur d'onde**
Wellenlängenabstimmbarer Laser mit externem Resonator
Wavelength tunable external cavity laser

(30) Priorité: 15.02.1999 FR 9901788
(43) Date de publication de la demande: 23.08.2000
(73) Titulaire: NETTEST PHOTONICS, 78340 Les Clayes Sous Bois (FR)
(72) Inventeur: Lefevre, Hervé, 75014 Paris (FR)
(74) Mandataire: Phélip, Bruno

(56) Documents cités:
- EP-A- 0 030 891
- EP-A- 0 459 650
- FR-A- 2 724 496
- PATENT ABSTRACTS OF JAPAN vol. 006, no. 185 (E-132), 21 septembre 1982 (1982-09-21) & JP 57 099793 A (TOMIJIMA TAKUMI), 21 juin 1982 (1982-06-21)
- BASIEV T.T., FEDIN A.V., GAVRILOV A.V., SMETANIN S.N.: "Powerful single mode Nd Lasers with self phase conjugation" PROCEEDINGS OF THE INTERNATIONAL CONFERENCE ON LASERS '98, 7 - 11 décembre 1998, pages 1044-1047, XP000852817 Tucson, AZ

## Description

La présente invention concerne une source laser accordable en longueur d'onde, éventuellement de manière continue, qui permette une extraction du faisceau lumineux de sortie dans des conditions optimisées, avec des pertes minimum.

Dans un mode de réalisation particulier de l'invention, il est possible d'obtenir un laser dont le bruit de fond résultant de l'émission ASE (Amplified Spontaneous Emission) soit filtré spectralement et qui présente donc une meilleure efficacité à la longueur d'onde d'émission du laser.

Un laser étant constitué d'une cavité résonnante dans laquelle est placé un milieu amplificateur, différents moyens sont connus pour extraire le flux utile ou flux source.

Le plus classique est la mise en oeuvre d'un miroir partiellement transparent à l'une des extrémité de la cavité. Le flux transmis par ce miroir est le flux source.

Toutefois, cette disposition ne donne pas toujours satisfaction, en particulier lorsque l'on veut produire un flux sans bruit de fond (ASE). On sait que pour cela, il faut introduire, dans la cavité, un réseau de diffraction qui filtre ce bruit. Le flux sortant doit alors être prélevé après sa diffraction sur le réseau, avant qu'il n'ait une nouvelle fois traversé le milieu amplificateur.

On peut alors introduire une lame semi-transparente supplémentaire dans la cavité et obtenir le flux sans ASE par réflexion sur l'une de ses faces. Toutefois cette disposition occasionne des pertes de flux importantes par réflexion sur l'autre face de la lame.

Les contraintes sont encore plus fortes dans les sources accordables à cavité externe. La variation de la longueur d'onde du flux sortant est généralement obtenue par la rotation du réseau placé dans la cavité. Différents moyens ont été envisagés pour extraire le flux utile sans ASE, mais ils imposent une rotation de la direction du faisceau produit lors de la variation de la longueur d'onde.

Le but de l'invention est de proposer une source laser, à cavité externe accordable dans laquelle le prélèvement du flux utile est optimisé et qui remédie aux inconvénients des solutions antérieures mentionnées plus haut.

L'invention concerne donc une source laser à cavité externe accordable en longueur d'onde comprenant un milieu amplificateur, une cavité résonnante, un réseau de diffraction placé dans la cavité comportant deux réflecteurs dont l'un est mobile en rotation de façon à permettre la variation de la longueur d'onde et des moyens d'extraction d'un faisceau source.

Selon l'invention, les moyens d'extraction d'un faisceau source comportent un séparateur de faisceaux produisant un premier faisceau (23) et un deuxième faisceau secondaires et des moyens réfléchissants renvoyant chacun des faisceaux secondaires vers le séparateur de faisceaux, le séparateur de faisceau et lesdits moyens réfléchissant formant un interféromètre de Sagnac ayant une sortie réciproque et une sortie non réciproque, le faisceau source étant obtenu à la sortie non réciproque de l'interféromètre de Sagnac.

De manière préférée, dans différents modes de réalisation présentant chacun leurs avantages respectifs :
- le séparateur de faisceaux des moyens d'extraction du faisceau source est placé entre le milieu amplificateur et le réseau
- le milieu amplificateur est un guide d'onde et qu'il est associé à une optique de collimation rendant collimaté le faisceau qu'il produit.
- la face externe du guide d'onde est totalement réfléchissante et que le faisceau non réciproque est le seul faisceau émis par la source.
- l'un des réflecteurs de la cavité résonnante est un réflecteur total auto-aligné à une dimension.
- le séparateur de faisceau est auto-aligné.
- le réseau de diffraction forme avec l'un des réflecteurs de la cavité résonnante, un système de Littman-Metcalf
- le réflecteur mobile en rotation l'est aussi en translation de façon à assurer la variation continue de la longueur d'onde.
- elle comporte plusieurs guides amplificateurs angulairement décalés par rapport au dispositif dispersif rétroréfléchissant et permettant l'émission de la source à plusieurs longueurs d'onde

Un mode de réalisation de l'invention sera décrit plus en détail en référence aux dessins annexés dans lesquels :

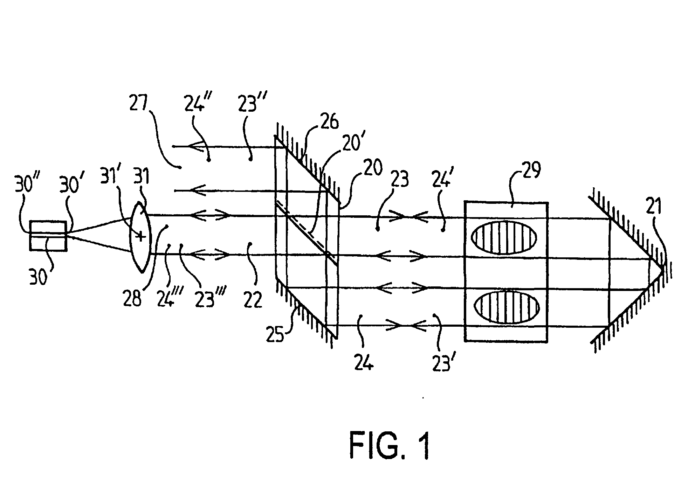

- la figure 1 est la vue de côté d'un laser selon l'invention ;
- la figure 2 est la vue de dessus d'un laser selon l'invention ;
- la figure 3 représente une lame à faces parallèles utilisable comme séparateur de faisceaux auto-aligné.

La source laser à cavité externe accordable en longueur d'onde comprend un milieu amplificateur 30, une cavité résonnante, un réseau de diffraction 29 placé dans la cavité qui comporte deux réflecteurs 21 et 30" dont l'un 21 est mobile en rotation de façon à permettre la variation de la longueur d'onde.

Les moyens d'extraction du faisceau source comportent un séparateur de faisceaux (20) produisant un premier faisceau (23) et un deuxième faisceau (24) secondaires, parallèles l'un à l'autre et des moyens réfléchissants(21,25,26) renvoyant chacun des faisceaux secondaires vers le séparateur de faisceaux.

Ce séparateur de faisceaux 20 et les moyens réfléchissants (21,25,26) forment un interféromètre de Sagnac qui a une sortie réciproque 28 et une sortie non réciproque 27. Le faisceau source étant obtenu à la sortie non réciproque de l'interféromètre de Sagnac. Cet interféromètre de Sagnac est réglé à la teinte plate.

Le milieu amplificateur, de préférence un guide d'onde amplificateur 30, dont l'extrémité interne 30' est placée au foyer de la lentille de collimation 31 de centre 31', génère le faisceau d'entrée collimaté 22. La face externe 30" de ce guide d'onde amplificateur 30 est entièrement réfléchissante, et le séparateur 20 est déséquilibré. Ainsi, on forme une cavité laser entre la face entièrement réfléchissante 30" et le réflecteur total auto-aligné 21 au travers de la sortie réciproque où le faisceau 28 est superposé au faisceau d'entrée 22. La sortie non réciproque 27 décalée constitue la sortie du laser et forme donc le faisceau émis.

La présence d'un réseau 29 dans la configuration de Littman-Metcalf avec le réflecteur total auto-aligné 21, dans cette source laser, permet, à la sortie non réciproque 27, de filtrer spectralement le fond continu parasite de rayonnement ASE et donc d'isoler la raie d'émission du laser.

Le réglage en longueur d'onde d'émission peut être obtenu soit par rotation du réseau, soit par rotation du réflecteur total 21, soit encore par rotation de l'ensemble formé par le réseau 29 et le réflecteur total 21, et le faisceau non réciproque filtré 27 reste stable car il est parallèle au faisceau d'entrée. Ce faisceau peut être éventuellement couplé dans une fibre optique monomode.

Un mouvement coordonné en rotation et/ou en translation du dièdre réflecteur 21 avec le mouvement du réseau 29 permet de réaliser une source laser à accordabilité continue. Un tel mouvement coordonné est par exemple décrit dans le brevet français FR-2.724.496.

Une telle source laser peut aussi être réalisée avec plusieurs milieux amplificateurs ou guides d'onde 30 placés dans le plan focal de la lentille 31. On constitue ainsi une source multilongueurs d'onde formée par la superposition de plusieurs flux laser, chacun correspondant à un guide d'onde et ayant une longueur d'onde dépendant de l'angle sous lequel ce guide d'onde est vu depuis le dispositif dispersif réfléchissant.

Le faisceau d'entrée 22 est divisé par le séparateur auto-aligné 20 en deux faisceaux parallèles : un premier faisceau séparé 23 et un deuxième faisceau séparé 24 se propageant en espace libre. Le premier faisceau séparé 23 est réfléchi par le réflecteur auto-aligné 21 et forme un faisceau séparé réfléchi 23' qui est dirigé vers le séparateur de faisceaux 20, qui le réfléchit partiellement et le transmet partiellement. Le faisceau transmis 23" est renvoyé parallèlement et dans le sens contraire au faisceau d'entrée 22.

Le faisceau réfléchi par le séparateur 20 est un faisceau 23''' superposé et de sens contraire au faisceau d'entrée 22. De manière analogue, le faisceau 24 produit à partir du faisceau d'entrée 22 par réflexion sur le séparateur 20, est lui-même réfléchi par le réflecteur total 21 et forme le faisceau 24' qui est renvoyé sur le séparateur 20 qui le divise en deux faisceaux, respectivement 24" et 24''', qui interfèrent avec les faisceaux 23" et 23''' produisant ainsi deux faisceaux de sortie, respectivement 27 et 28, parallèles entre eux. Le faisceau 28 est produit par l'interférence des faisceaux 23''' et 24''' qui ont chacun subi une seule réflexion sur le séparateur 20. Ce faisceau 28, dit réciproque, est superposé au faisceau d'entrée 22 et de sens contraire.

Au contraire, le faisceau 27 est produit par les interférences du faisceau 23" qui n'a subi aucune réflexion sur le séparateur 20 et du faisceau 24" qui a subi deux réflexions sur ce même séparateur. Cette différence de nombre de réflexions subies par chacun des faisceaux introduit un déphasage de π radian et la sortie 27 est dite sortie non réciproque.

La mise en oeuvre d'un réflecteur total auto-aligné 21 facilite le réglage du dispositif et améliore donc son rendement. A partir d'un faisceau d'entrée 22, on produit ainsi deux faisceaux, respectivement réciproque 28 et non réciproque 27, parallèles entre eux et auto-alignés sur le faisceau d'entrée. Le faisceau réciproque 28 est superposé au faisceau d'entrée 22 alors que le faisceau non réciproque 27 est décalé.

Le séparateur 20 est déséquilibré en énergie, permettant la répartition de l'énergie incidente entre les deux faisceaux de sortie 27 et 28. R et T étant respectivement les coefficients de réflexion et de transmission en énergie du séparateur 20, on trouve à la porte non réciproque (1 - 4 RT) de l'énergie entrante. Par exemple avec R = 90 % et T = 10 %, on obtient (1-4 RT) = 64 % à la porte non réciproque.

Le séparateur auto-aligné 20 peut avantageusement être un séparateur périscopique composé d'une interface séparatrice 20' et de deux miroirs 25 et 26 qui lui sont parallèles.

Les figures et la description ont été faites en utilisant comme réflecteur auto-aligné, un dièdre assurant l'autoalignement dans une dimension. Des résultats analogues peuvent être obtenus en utilisant un oeil-de-chat, c'est à dire une lentille cylindrique associée à un miroir placé dans son plan focal. Le dièdre peut être constitué de miroirs plans mais aussi fabriqués à partir d'un d'un prisme isocèle rectangle fonctionnant en réflexion interne totale.

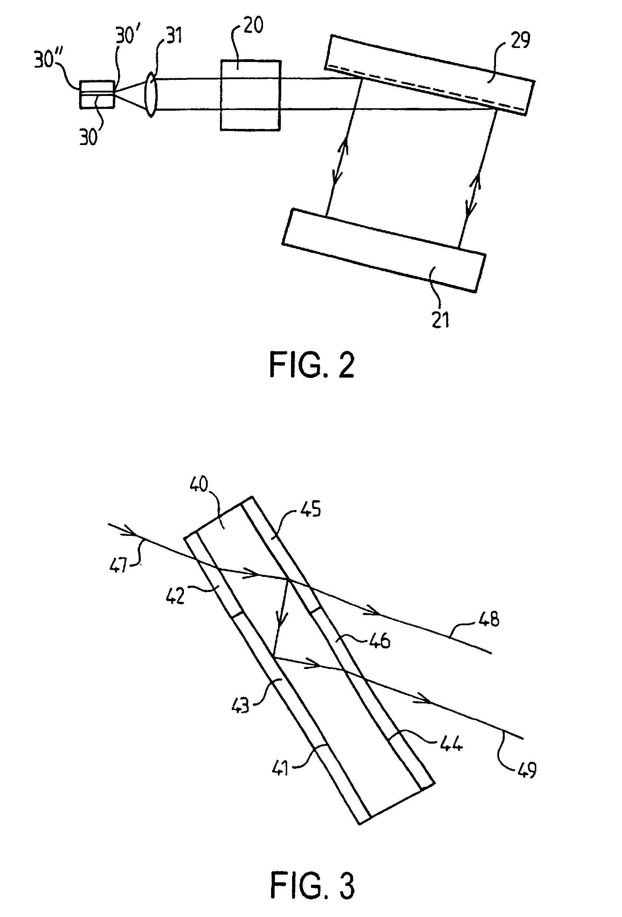

Il a été mentionné plus haut que le séparateur auto-aligné 20 peut être un séparateur périscopique. Il peut être aussi une lame à faces parallèles. Une telle lame 40 est représentée sur la figure 3.

Sa face d'entrée 41 est partiellement recouverte d'un traitement antireflet 42 et d'un traitement entièrement réfléchissant 43.

Sa face de sortie 44 est partiellement recouverte d'un traitement partiellement réfléchissant 45 et sur une autre zone, d'un traitement antireflet 46.

Ainsi, un faisceau incident 47 est partiellement transmis en 48 et le flux restant est transmis, après deux réflexions en 49. On obtient donc ainsi la fonction voulue.

## Revendications

1. Source laser à cavité externe accordable en longueur d'onde comprenant un milieu amplificateur, une cavité résonnante, un réseau de diffraction placé dans la cavité qui comporte deux réflecteurs dont l'un est mobile en rotation de façon à permettre la variation de la longueur d'onde et des moyens d'extraction d'un faisceau source, **caractérisée en ce que** les moyens d'extraction d'un faisceau source comportent un séparateur de faisceaux (20) produisant un premier faisceau (23) et un deuxième faisceau (24) secondaires et des moyens réfléchissants(21,25,26) renvoyant chacun des faisceaux secondaires vers le séparateur de faisceaux, le séparateur de faisceaux et lesdits moyens réfléchissants formant un interféromètre de Sagnac ayant une sortie réciproque et une sortie non réciproque, le faisceau source étant obtenu à la sortie non réciproque de l'interféromètre de Sagnac.

2. Source laser à cavité externe selon la revendication 1, **caractérisée en ce que** le séparateur de faisceaux des moyens d'extraction du faisceau source est placé entre le milieu amplificateur et le réseau

3. Source laser à cavité externe selon l'une des revendications 1 et 2, **caractérisée en ce que** le milieu amplificateur est un guide d'onde et qu'il est associé à une optique de collimation rendant collimaté le faisceau qu'il produit.

4. Source laser à cavité externe selon la revendication 3, **caractérisée en ce que** la face externe du guide d'onde est totalement réfléchissante et que le faisceau non réciproque (27) est le seul faisceau émis par la source.

5. Source laser à cavité externe selon l'une quelconque des revendications 1 à 4, **caractérisée en ce que** l'un des réflecteurs de la cavité résonnante est un réflecteur total auto-aligné(21).à une dimension

6. Source laser à cavité externe selon l'une quelconque des revendications 1 à 5, **caractérisée en ce que** le séparateur de faisceau (20) est auto-aligné.

7. Source laser à cavité externe selon l'une quelconque des revendications 1 à 5, **caractérisée en ce que** le réseau de diffraction forme avec l'un des réflecteurs de la cavité résonnante, un système de Littman-Metcalf

8. Source laser à cavité externe selon la revendication 4, **caractérisée en ce que** le réflecteur mobile en rotation l'est aussi en translation de façon à assurer la variation continue de la longueur d'onde.

9. Source laser à cavité externe selon l'une quelconque des revendications 1 à 7, **caractérisée en ce qu'**elle comporte plusieurs guides amplificateurs angulairement décalés par rapport au dispositif dispersif rétroréfléchissant et permettant l'émission de la source à plusieurs longueurs d'onde

## Patentansprüche

1. Laserquelle mit externem Hohlraum, die an eine Wellenlänge angepasst werden kann, umfassend ein verstärkendes Milieu, einen Resonanzhohlraum, ein in dem Hohlraum angeordnetes Diffraktionsnetz, das zwei Reflektoren umfasst, von welchen einer drehbar beweglich ist, derart, dass das Variieren der Wellenlänge möglich ist, und Mittel zum Extrahieren eines Quellenstrahls, **dadurch gekennzeichnet, dass** die Mittel zum Extrahieren eines Quellenstrahls einen Strahlenteiler (20), der einen ersten Sekundärstrahl (23) und einen zweiten Sekundärstrahl (24) erzeugt, und reflektierende Mitte) (21, 25, 26), die jeden der Sekundärstrahlen zum Strahlenteiler zurücksenden, umfassen, wobei der Strahlenteiler und die reflektierenden Mittel ein Sagnac-Interferometer bilden, das einen reziproken und einen nicht reziproken Ausgang hat, wobei der Quellenstrahl an dem nicht reziproken Ausgang des Sagnac-Interferometers erhalten wird.

2. Laserquelle mit externem Hohlraum nach Anspruch 1, **dadurch gekennzeichnet, dass** der Strahlenteiler der Mittel zum Extrahieren des Quellenstrahls zwischen dem verstärkenden Milieu und dem Netz angeordnet ist.

3. Laserquelle mit externem Hohlraum nach einem der Ansprüche 1 und 2, **dadurch gekennzeichnet, dass** das verstärkende Milieu ein Wellenleiter ist und dass er einer Kollimationsoptik zugeordnet ist, die den Strahl, den er erzeugt, kollimiert.

4. Laserquelle mit externem Hohlraum nach Anspruch 3 **dadurch gekennzeichnet, dass** die externe Seite des Wellenleiters vollständig reflektierend ist und dass der nicht reziproke Strahl (27) der einzige von der Quelle gesendete Strahl ist.

5. Laserquelle mit externem Hohlraum nach einem der Ansprüche 1 bis 4, **dadurch gekennzeichnet, dass** einer der Reflektoren des Resonanzhohlraums ein totaler, auf eine Dimension selbstgerichteter Reflektor (21) ist.

6. Laserquelle mit externem Hohlraum nach einem der Ansprüche 1 bis 5, **dadurch gekennzeichnet, dass** der Strahlenteiler (20) selbstgerichtet ist.

7. Laserquelle mit externem Hohlraum nach einem der Ansprüche 1 bis 5, **dadurch gekennzeichnet, dass** das Diffraktionsnetz mit einem der Reflektoren des Resonanzhohlraums ein Littman-Metcalf-System bildet.

8. Laserquelle mit externem Hohlraum nach Anspruch 4, **dadurch gekennzeichnet, dass** der drehbar bewegliche Reflektor auch translatorisch derart beweglich ist, dass die ständige Variation der Wellenlänge gewährleistet ist.

9. Laserquelle mit externem Hohlraum nach einem der Ansprüche 1 bis 7, **dadurch gekennzeichnet, dass** sie mehrere verstärkende Wellenleiter umfasst, die in Bezug auf die dispergierende reflektierende Vorrichtung winklig versetzt sind und das Senden der Quelle auf mehreren Wellenlängen erlauben.

## Claims

1. A wavelength tuneable laser source with external cavity comprising an amplifier medium, a resonant cavity, a diffraction grating placed in the cavity comprising two reflectors one of which is able to rotate so as to tune the wavelength and source beam extraction means wherein said source beam extraction means comprise a beam splitter giving a first secondary beam and a second secondary beam, as well as retroreflecting means redirecting each secondary beams toward the beam splitter and forming a Sagnac interferometer having a reciprocal output and a non-reciprocal output, the source beam being obtained on the Sagnac interferometer non-reciprocal output beam.

2. A wavelength tuneable laser source according to claim 1 wherein the beam spitter of the extraction means are placed between the amplifier medium and the grating.

3. A wavelength tuneable laser source according to any of claims 1 and 2 wherein the amplifier medium is a wave guide and it is associated with collimation optics that collimate the beam thereby produced.

4. A wavelength tuneable laser source according to claim 3 wherein the external face of the wave guide is totally reflecting and the non reciprocal beam is the single beam emitted by the source.

5. A wavelength tuneable laser source according to any of claims 1 to 4 wherein one of the cavity reflector is a self-aligned reflector.

6. A wavelength tuneable laser source according to any of claims 1 to 5 wherein the beam splitter is self-aligned.

7. A wavelength tuneable laser source according to any of claims 1 to 5 wherein the diffraction grating forming with one of the reflectors of the resonant cavity a Littman-Metcalf system.

8. A wavelength tuneable laser source according to claim 4 wherein the reflector which is mobile in rotation is also mobile in translation to enable continuous variation of the wavelength

9. A wavelength tuneable laser source according to any of claims 1 to 7 wherein it comprises several amplifier guides that are offset at an angle with respect to the retroreflecting-dispersing device and enabling the emission of the source over several wavelengths.
